(19) Europäisches Patentamt / European Patent Office / Office européen des brevets

(11) **EP 3 157 999 B1**

(12) **FASCICULE DE BREVET EUROPEEN**

(45) Date de publication et mention de la délivrance du brevet:
**25.07.2018 Bulletin 2018/30**

(21) Numéro de dépôt: **15736541.2**

(22) Date de dépôt: **08.06.2015**

(51) Int Cl.:
*C08L 23/08* (2006.01)    *C08K 5/5419* (2006.01)
*C08L 33/08* (2006.01)    *C08L 33/14* (2006.01)
*C08L 35/00* (2006.01)    *H01L 31/048* (2014.01)

(86) Numéro de dépôt international:
**PCT/FR2015/051507**

(87) Numéro de publication internationale:
**WO 2015/193581 (23.12.2015 Gazette 2015/51)**

(54) **ENCAPSULANT D'UN MODULE PHOTOVOLTAÏQUE**

VERKAPSELUNGSMITTEL EINES PHOTOVOLTAIKMODULS

ENCAPSULANT OF A PHOTOVOLTAIC MODULE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **18.06.2014 FR 1455583**

(43) Date de publication de la demande:
**26.04.2017 Bulletin 2017/17**

(73) Titulaire: **Arkema France**
**92700 Colombes (FR)**

(72) Inventeurs:
• **JACQUES, Guillaume**
**2215MJ Voorhout (NL)**
• **BIZET, Stéphane**
**F-27170 Barc (FR)**
• **SAVIGNAT, Benoît**
**F-27300 Bernay (FR)**

(74) Mandataire: **Gorintin, Sarah et al**
**ARKEMA France**
**Département Propriété Industrielle**
**420, rue d'Estienne d'Orves**
**92705 Colombes Cedex (FR)**

(56) Documents cités:
**EP-A2- 0 334 205      WO-A1-2011/014777**
**US-A1- 2012 024 351      US-A1- 2012 048 354**

## Description

### Domaine de l'invention

L'invention a pour objet un encapsulant de module photovoltaïque à base d'un copolymère d'éthylène - acrylate d'alkyle dans lequel aucun agent de réticulation n'est présent (peroxydes ou isocyanates ou tout autre composant ayant une fonction de réticulation). La présente invention concerne également un module photovoltaïque, ou l'utilisation de cette composition d'encapsulant dans un tel module, comprenant, outre la couche d'encapsulant, au moins une couche adjacente formant « frontsheet » ou « backsheet », plus généralement ces trois couches successives, « frontsheet », encapsulant et « backsheet ».

Le réchauffement climatique, lié aux gaz à effet de serre dégagés par les énergies fossiles, a mené au développement de solutions énergétiques alternatives qui n'émettent pas de tels gaz lors de leur fonctionnement, comme par exemple les modules photovoltaïques. Un module photovoltaïque comprend une « pile photovoltaïque », cette pile étant capable de transformer l'énergie lumineuse en électricité.

Il existe de nombreux types de structures de panneaux photovoltaïques.

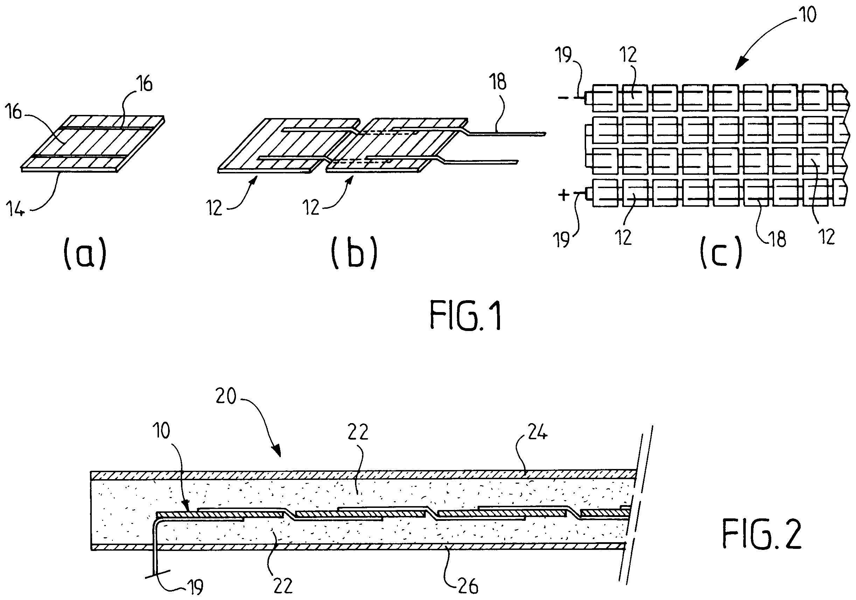

Sur la Figure 1, on a représenté une pile photovoltaïque classique ; cette pile photovoltaïque 10 comprend des cellules 12, une cellule contenant un capteur photovoltaïque 14, généralement à base de silicium traité afin d'obtenir des propriétés photoélectriques, en contact avec des collecteurs d'électrons 16 placés au-dessus (collecteurs supérieurs) et au-dessous (collecteurs inférieurs) du capteur photovoltaïque. Les collecteurs 16 supérieurs d'une cellule sont reliés aux collecteurs 16 inférieurs d'une autre cellule 12 par des barres conductrices 18, constituées généralement d'un alliage de métaux. Toutes ces cellules 12 sont connectées entre elles, en série et/ou en parallèle, pour former la pile photovoltaïque 10. Lorsque la pile photovoltaïque 10 est placée sous une source lumineuse, elle délivre un courant électrique continu, qui peut être récupéré aux bornes 19 de la pile 10.

En référence à la Figure 2, le module photovoltaïque 20 comprend la pile photovoltaïque 10 de la Figure 1 enrobée dans un « encapsulant », celui-ci étant composé d'une partie supérieure 22 et d'une partie inférieure. Une couche protectrice supérieure 24 (connue en anglais sous le terme « frontsheet », utilisé dans la suite) et une couche protectrice au dos du module (connue en anglais sous le terme « backsheet », également utilisé dans la suite) 26 sont disposées de part et d'autre la pile encapsulée.

La protection au choc et à l'humidité de la pile photovoltaïque 10 est assurée par la couche protectrice supérieure 24, généralement en verre.

Le backsheet 26, par exemple un film multicouche à base de polymère fluoré et de polyéthylène téréphtalate, contribue à la protection à l'humidité du module photovoltaïque 20 et à l'isolation électrique des cellules 12 pour éviter tout contact avec l'environnement extérieur.

L'encapsulant 22 doit épouser parfaitement la forme de l'espace existant entre la pile photovoltaïque 10 et les couches protectrices 24 et 26 afin d'éviter la présence d'air, ce qui limiterait le rendement du module photovoltaïque. L'encapsulant 22 doit également empêcher le contact des cellules 12 avec l'eau et l'oxygène de l'air, afin d'en limiter la corrosion. La partie supérieure de l'encapsulant 22 est comprise entre la pile 10 et la couche protectrice supérieure 24. La partie inférieure de l'encapsulant 22 est comprise entre la pile 10 et le backsheet 26.

En présence de rayonnement solaire, il se crée un échauffement à l'intérieur du module solaire et des températures de 80°C (ou plus) peuvent être atteintes ce qui nécessite que les couches soient parfaitement liées les unes aux autres tout au long du cycle de vie du module.

### Etat de l'art

A l'heure actuelle, la majorité du marché de l'encapsulation photovoltaïque correspond à des formulations à base d'un EVA dans lequel on ajoute un peroxyde, un silane et divers additifs fonctionnels.

L'EVA présente beaucoup de qualités et de propriétés intéressantes pour cette application. Il confère en effet principalement de très bonnes propriétés de transparence, de tenue mécanique, de résistance au vieillissement et de manière générale d'excellentes propriétés thermomécanique et mécanique. Par ailleurs, ce thermoplastique est relativement peu couteux de sorte que son emploi pour cette application est devenu quasiment incontournable.

Néanmoins, le type d'encapsulant à base d'EVA, avec peroxyde et silane, présente deux inconvénients majeurs.

Tout d'abord, l'utilisation d'un agent de réticulation, à savoir le peroxyde, présente l'inconvénient d'une mise en oeuvre relativement longue, nécessaire au respect de la cinétique de réactivité du peroxyde ; le temps de cycle actuel, pour la fabrication d'un module utilisant un tel encapsulant, étant compris entre 15 et 45 minutes. Néanmoins, à l'heure actuelle, l'utilisation d'un agent de réticulation est nécessaire, en particulier pour l'EVA, pour conférer à ce dernier de meilleures propriétés thermomécaniques et caractéristiques physico-chimiques ainsi que pour assurer le greffage du silane sur les chaînes de polymère.

Concernant l'EVA, lorsque les conditions d'environnement sont dégradées, c'est-à-dire lorsqu'il vieillit dans des conditions chaudes et humides (DHT « Damp Heat Test » : 85°C / 85% HR « Humidité Relative »), ce composant est sujet à de l'hydrolyse qui provoque l'apparition d'acide acétique, source de jaunissement de l'encapsulant et de corrosion des connectiques métalliques du module photovoltaïque.

L'homme du métier pourrait envisager le remplacement de l'EVA par un copolymère éthylène - acrylate d'alkyle mais cette solution, qui évite certes les problèmes spécifiques liés à l'EVA lorsque celui-ci est présent dans un environnement difficile, ne permet pas l'obtention d'un module photovoltaïque correct. En effet, lors de la lamination, de nombreuses bulles se forment au cours de la réticulation en raison du peroxyde présent en quantités notables.

Par ailleurs, le document WO 2006095911 propose une solution par l'utilisation d'une formulation à base d'un copolymère éthylène - acrylate d'alkyle dont la température de fusion (T en °C), obtenue selon la norme JIS K 7121, répondrait à la formule suivante : -3.0X+125 > T >-3.0X+109. L'élément X représentant le taux molaire du comonomaire polaire (acrylate). Par ailleurs ce document propose l'association à ce copolymère d'un silane afin d'apporter les propriétés adhésives sur le verre.

Cependant, une telle formulation ne permettrait pas l'obtention d'un encapsulant performant sur le long terme. Le silane présente en effet l'inconvénient de ne pas permettre un bon niveau d'adhésion sur le verre lorsqu'il n'est pas chimiquement lié au polymère.

Ainsi, il est recherché à l'heure actuelle une solution d'encapsulation à base d'un composant alternatif à l'EVA, mais présentant des propriétés tout aussi intéressantes, tout en n'utilisant pas d'agents de réticulation.

Cette solution devra par ailleurs permettre l'utilisation d'un promoteur d'adhésion, tel qu'un silane, permettant en particulier la fixation aux parois du « frontsheet », c'est-à-dire à un composant en verre céramique ou en verre synthétique (classiquement du PMMA) et conservant de bonnes propriétés adhésives sur le frontsheet au cours de son utilisation.

## Brève description de l'invention

Il a été constaté par la demanderesse, après diverses expériences et manipulations, qu'une composition à base d'un copolymère d'éthylène - acrylate d'alkyle et de silane pouvait, sans utiliser aucun agent de réticulation, présenter des propriétés thermomécaniques et des caractéristiques physico-chimiques extrêmement satisfaisantes lorsqu'elle était associée à une polyoléfine fonctionnalisée d'un type très particulier.

Cette polyoléfine très particulière consiste en le terpolymère éthylène - acrylate d'alkyle - anhydride maléique.

Ainsi, la présente invention concerne un encapsulant de module photovoltaïque, destiné à venir enrober une pile photovoltaïque, constitué par une composition ne comprenant aucun agent de réticulation et comprenant :

- un copolymère éthylène - acrylate d'alkyle, ledit copolymère représentant entre 70% et 96% du poids de ladite composition ;
- un silane, représentant entre 0,1% et 2% du poids de ladite composition ;

caractérisé en ce qu'elle comprend en outre un terpolymère éthylène - acrylique ester - anhydride maléique ou méthacrylate de glycidyle, ledit terpolymère représentant de 2% à 29,9% du poids de ladite composition

La composition selon l'invention présente en premier lieu les avantages suivants :

- l'impossibilité d'apparition d'acide acétique, plus généralement d'aucun acide, au cours de son utilisation quelque soit les conditions d'environnements ;
- une très grande latitude concernant les paramètres d'extrusion du film de composition et un gain de temps significatif sur l'étape de lamination ;
- le maintien d'excellentes propriétés adhésives de la composition tout au long de la durée de vie de la composition, en particulier dans son emploi en tant qu'encapsulant d'un module photovoltaïque ;
- le maintien d'excellentes propriétés thermomécaniques et de caractéristiques physico-chimiques, au moins aussi satisfaisantes que la solution actuelle à base d'EVA (agent de réticulation et silane).

D'autres caractéristiques et particularités du mélange primaire de l'invention sont présentées ci-après :

- avantageusement, le susdit terpolymère représente entre 8% et 22% du poids de ladite composition ;
- de préférence, pour le susdit copolymère, le taux massique d'éthylène est compris entre 60% et 85%, de préférence entre 70% et 84%, et le taux massique d'acrylate d'alkyle est compris entre 15% et 40%, de préférence entre 16% et 30% ;
- avantageusement le silane consiste en un époxysilane ou un aminosilane ;
- dans ce dernier cas, avantageusement, le silane consiste en le glycidyl-3-oxypropyl-triéthoxy-silane ;
- le susdit copolymère est présent entre 75% et 95% en poids de ladite composition ;

- selon une possibilité offerte par l'invention, la composition consiste uniquement en les susdits copolymère, terpolymère et silane ;
- selon un mode de réalisation, la composition comprend en outre des additifs destinés à conférer des propriétés particulières additionnelles, en particulier des plastifiants, des promoteurs d'adhésion, des stabilisants et absorbeurs UV, des antioxydants, des agents retardateurs de flamme et/ou des charges.

L'invention se rapporte également à l'utilisation de l'encapsulant tel que décrit ci-dessus dans un module photovoltaïque.

Enfin, l'invention se rapporte à un module photovoltaïque comprenant une structure constituée d'une association d'au moins un encapsulant et un frontsheet ou backsheet, caractérisé en ce que l'encapsulant est tel que décrit ci-dessus.

## Description des Figures annexées

La description qui va suivre est donnée uniquement à titre illustratif et non limitatif en référence aux figures annexées, dans lesquelles :

La Figure 1, déjà décrite, représente un exemple de pile photovoltaïque, les parties (a) et (b) étant des vues de ¾, la partie (a) montrant une cellule avant connexion et la partie (b) une vue après connexion de 2 cellules ; la partie (c) est une vue de dessus d'une pile photovoltaïque complète.

La Figure 2, déjà décrite, représente une coupe transversale d'un module photovoltaïque, dont le capteur photovoltaïque « classique » est encapsulé par un film d'encapsulant supérieur et un film d'encapsulant inférieur.

## Description détaillée de l'invention

S'agissant du copolymère éthylène - acrylate d'alkyle, il s'agit d'un composant bien connu de l'homme du métier. Les particularités propres à ce copolymère, dans le cadre de la présente invention, proviennent essentiellement des proportions massiques (ou en poids) d'éthylène et d'acrylate d'alkyle, le taux massique d'éthylène étant compris entre 60% et 85%, de préférence entre 70% et 84%, et le taux massique d'acrylate d'alkyle est compris entre 15% et 40%, de préférence entre 16% et 30%. Ce copolymère sera obtenu préférentiellement selon un procédé de polymérisation dit tubulaire, permettant l'obtention d'un copolymère à propriétés thermiques améliorées (comparativement au même copolymère obtenu selon le procédé dit autoclave).

A titre d'exemple non limitatif, la demanderesse exploite commercialement un composant dénommé LOTRYL® qui est un copolymère éthylène - acrylate d'alkyle.

L'homme du métier sait parfaitement comment réaliser/fabriquer un tel copolymère, selon les différentes quantités de chacun de deux monomères. Dans la suite, l'invention est présentée avec un copolymère éthylène - acrylate d'alkyle de type spécifique mais il a été démontré par la titulaire que la composition d'encapsulant selon l'invention répondait aux objectifs fixés lorsque le copolymère varie dans les domaines de taux d'éthylène et d'acrylate d'alkyle définis ci-dessus, éventuellement de façon légèrement supérieure lorsque ledit copolymère présente des taux d'éthylène et d'acrylate d'alkyle choisis dans les domaines préférés pour ces deux monomères.

S'agissant du silane, ce sont des composés chimiques permettant les interactions d'adhésion entre l'encapsulant et le verre. A titre d'exemples de silane, on peut citer les aminosilanes et époxysilanes ou tout autre silane porteur d'une fonction réactive vis-à-vis du terpolymère. De préférence, le silane dans la composition selon l'invention est le glycidyloxypropyltriethoxysilane. Néanmoins, on obtiendrait des résultats équivalent ou sensiblement équivalent en choisissant un autre silane de la famille des époxysilanes ou aminosilanes.

S'agissant du terpolymère d'éthylène -ester acrylique - anhydride maléique, ce composant réactif est bien connu de l'homme du métier et il ne présente aucune difficulté pour sa fabrication/préparation.

La composition formant l'encapsulant selon l'invention pourra comprendre un certains nombres d'additifs destinés à conférer des propriétés particulières additionnelles.

Des plastifiants pourront être ajoutés afin de faciliter la mise en oeuvre et améliorer la productivité du procédé de fabrication de la composition et des structures. On citera comme exemples les huiles minérales paraffiniques aromatiques ou naphtaléniques qui permettent également d'améliorer le pouvoir d'adhérence de la composition selon l'invention. On peut également citer comme plastifiant les phtalates, azelates, adipates, le phosphate de ticrésyle.

Des promoteurs d'adhésion, bien que non nécessaires, peuvent être avantageusement ajoutés afin d'améliorer le pouvoir d'adhérence de la composition lorsque celui-ci doit être particulièrement élevé. Le promoteur d'adhésion est un ingrédient non polymérique ; il peut être organique, cristallin, minéral et plus préférentiellement semi-minéral semi-organique. Parmi ceux-ci, on peut citer les titanates.

Dans cette application particulière de la composition aux modules photovoltaïques, le rayonnement UV étant susceptible d'entraîner un léger jaunissement de la composition utilisée en tant qu'encapsulant desdits modules, des stabilisants UV et des absorbeurs UV tels que le benzotriazole, le benzophénone et les autres amines encombrés, peuvent être ajoutés afin d'assurer la transparence de l'encapsulant durant sa durée de vie. Ces composés peuvent être par exemple à base de benzophénone ou de benzotriazole. On peut les ajouter dans des quantités inférieures à 10% en masse de la masse totale de la composition et préférentiellement de 0,05 à 3%.

On pourra également ajouter des anti-oxydants pour limiter le jaunissement lors de la fabrication de l'encapsulant tels que les composés phosphorés (phosphonites et/ou phosphites) et les phénoliques encombrés. On peut ajouter ces anti-oxydants dans des quantités inférieures à 10% en masse de la masse totale de la composition et préférentiellement de 0,05 à 3%.

Des agents retardateurs de flamme peuvent également être ajoutés. Ces agents peuvent être halogénés ou non-halogénés. Parmi les agents halogénés, on peut citer les produits bromés. On peut également utiliser comme agent non-halogéné les additifs à base de phosphore tels que le phosphate d'ammonium, de polyphosphate, de phosphinate ou de pyrophosphate, le cyanurate de mélamine, le pentaérythritol, les zéolithes ainsi que les mélanges de ces agents. La composition peut comprendre ces agents dans des proportions allant de 3 à 40% par rapport à la masse totale de la composition.

On peut également ajouter des pigments comme par exemple le dioxyde de titane, des composés colorants ou azurants dans des proportions allant généralement de 5% à 15% par rapport à la masse totale de la composition.

Des charges, en particulier minérales, peuvent également être ajoutées pour améliorer la tenue thermomécanique de la composition. De façon non limitative, on donnera comme exemples la silice, l'alumine ou les carbonates de calcium ou les nanotubes de carbone ou encore les fibres de verre. On pourra utiliser des argiles modifiées ou non modifiées qui sont mélangées à l'ordre nanométrique ; ceci permet d'obtenir une composition plus transparente.

Préparation de l'encapsulant et production d'un film encapsulant selon l'invention (destiné à être incorporé dans un module photovoltaïque) :

Classiquement, une réticulation est nécessaire pour adapter les propriétés thermomécaniques de l'encapsulant à base d'EVA, en particulier lorsque la température devient très élevée. En l'occurrence, dans le cadre de la présente invention, la réticulation n'est pas nécessaire et seules des interactions et réactions chimiques classiques ont lieu entre la polyoléfine fonctionnalisée (le terpolymère) et le copolymère éthylène - acrylate d'alkyle et entre la polyoléfine fonctionnalisée et le silane.

Relativement aux aspects susvisés, le manuel intitulé « Handbook of polymer foams and technology », notamment aux pages 198 à 204, fournit des enseignements complémentaires auxquels l'homme du métier peut se référer.

Concernant les aspects de l'invention relatifs à l'utilisation de la composition thermoplastique dans un module photovoltaïque, l'Homme de l'Art peut se référer par exemple au « Handbook of Photovoltaic Science and Engineering », Wiley, 2003. En effet, la composition de l'invention peut être utilisée en tant qu'encapsulant ou encapsulant-backsheet dans un module photovoltaïque, dont on décrit la structure en relation avec les figures annexées.

**Matériaux employés pour former les formulations testées :**

**Lotryl® 20MA08 :** copolymère éthylène - acrylate de méthyle dont le taux d'acrylate est de 20% en poids du copolymère et le MFI de 8 g/10 min. (190°C, 2,13 kg). Il peut être obtenu selon :

- un procédé tubulaire : Température de fusion = 96°C
- un procédé autoclave : Température de fusion = 75°C

Dans les tableaux de résultats présentés ci-après, ce Lotryl® est noté par les initiales 20MA08T lorsqu'il a été obtenu par le procédé tubulaire, et 20MA08A lorsqu'il a été obtenu par le procédé autoclave.

**Lotryl® 24MA02** : copolymère éthylène - acrylate de méthyle dont le taux d'acrylate est de 24% en poids du copolymère et le MFI de 2 g/10 min. (190°C, 2,13 kg). Il peut être obtenu selon :

- un procédé tubulaire : Température de fusion = 93°C
- un procédé autoclave : Température de fusion = 68°C

Dans les tableaux de résultats présentés ci-après, ce Lotryl® est noté par les initiales 24MA02T lorsqu'il a été obtenu par le procédé tubulaire, et 24MA02A lorsqu'il a été obtenu par le procédé autoclave.

**Lotader® 3410** : terpolymère éthylène - acrylate de butyle - anhydride maléïque, dont le taux d'acrylate est de 17% en poids du terpolymère, le taux d'anhydride est de 3,1% en poids du terpolymère et le MFI de 5 g/10 min. (190°C, 2,13 kg). Dans les tableaux de résultats présentés ci-après, ce Lotader® est noté par l'appellation 3410.

**Dynasylan® GLYEO** : Glycidyloxypropyltriethoxysilane vendu par la société Evonik. Il s'agit d'un silane possédant une fonction époxide réactive et un groupe triethoxysilyl hydrolysable. Dans les tableaux de résultats présentés ci-après, ce silane est noté par les initiales GLYEO.

**Evatane® 3345PV :** copolymère éthylène - acétate de vinyle dont le taux d'acétate est de 33% en poids du copolymère et le MFI de 45 g/10 min. (190°C, 2,13 kg). Dans les tableaux de résultats présentés ci-après, cet Evatane® est noté par les initiales 3345PV.

**Dynasylan® MEMO :** 3-MethacryloxypropylTrimethoxySilane vendu par la société Evonik. Dans les tableaux de résultats présentés ci-après, ce silane est noté par les initiales MTS.

**Luperox® TBEC :** OO-tert-butyl-O-(2-éthylhexyle)-monoperoxycarbonate, vendu par la société demanderesse Arkema, noté dans la suite TBEC.

**Obtention des films et formulations testées :**

Réalisation des films :

Les films encapsulants sont obtenus par extrusion de granulés de polymères imprégnés : les silanes et, le cas échéant, le peroxyde sont ajoutés par imprégnation des granulés de Lotryl ou Evatane. Granulés et liquide sont placés dans un flacon et le flacon est disposé sur un mélangeur à rouleaux durant environ 3 heures à la vitesse de 60 rotations par minute.

Après imprégnation, ces granulés, ainsi que les granulés éventuellement additionnels, sont placés dans la trémie d'introduction d'une extrudeuse à filière plate de largeur 10 cm (centimètre).

L'extrusion est réalisée à une température adaptée à la composition, ainsi pour le contre-exemple à base d'Evatane et Luperox TBEC (composition EC1), cette température est limitée à 90°C, car au-delà de celle-ci, le peroxyde se décomposerait.

Dans le cas de formulations telles que décrites dans cette invention, la température n'est limitée que par les propriétés thermiques du polymère utilisé. Il conviendra cependant de réaliser cette extrusion à une température comprise entre 100°C et 220°C.

Cette extrusion permet l'obtention d'une bobine de film dont le tirage en sortie d'extrudeuse est réglé de façon à obtenir un film d'épaisseur comprise entre 350 et 550 $\mu$m (micromètre).

Réalisation des modules test :

Afin de caractériser les formulations, des modules-test sont obtenus par lamination à chaud.

La structure d'un module-test est variable selon les caractérisations à réaliser :

- Mesure de fluage et de propriétés optiques par transmission : Verre (4mm) / Film d'encapsulant / Verre (4mm)

- Mesure de propriétés optiques par réflexion : Verre (4mm) / Film d'encapsulant / Backsheet KPK (PVDF / PET / PVDF)

- Mesure d'adhésion : Verre (4mm) / Film d'encapsulant / Backsheet Apolhya

Le laminateur utilisé est fourni par la société Penergy. Les conditions de lamination (Durée, Température T, Pressions des chambres supérieure et inférieure respectivement $V_{up}$ et $V_{down}$) sont dépendantes de la composition des films laminés.

Ainsi dans le cas d'une formulation « classique », le cycle respecté est le suivant (durée totale : 20 minutes) :

|  | Durée (s) | T (°C) | $V_{up}$ (mBar) | $V_{down}$ (mBar) |
|---|---|---|---|---|
| Prestart | 10 | 85 | 0 | 1000 |
| 1 | 10 | 85 | 0 | 0 |
| 2 | 180 | 85 | 0 | 0 |
| 3 | 10 | 85 | 900 | 0 |
| 4 | 10 | 85 | 1000 | 0 |
| 5 | 600 | 150 | 1000 | 0 |
| 6 | 360 | 150 | 1000 | 0 |

(suite)

|   | Durée (s) | T (°C) | $V_{up}$ (mBar) | $V_{down}$ (mBar) |
|---|---|---|---|---|
| 7 | 10 | 150 | 0 | 0 |
| 8 | 10 | 150 | 0 | 0 |
| 9 | - | 50 | 0 | 1000 |

Dans le cas d'une formulation telle que décrite dans la présente invention, le cycle respecté est le suivant (durée totale : 8 minutes) :

|   | Durée (s) | Température (°C) | $V_{up}$ (mB) | $V_{down}$ (mB) |
|---|---|---|---|---|
| Prestart | 10 | 150 | 0 | 0 |
| 1 | 300 | 150 | 0 | 0 |
| 2 | 10 | 150 | 1000 | 0 |
| 3 | 150 | 150 | 1000 | 0 |
| 4 | 10 | 150 | 0 | 1000 |
| 5 | - | 150 | 0 | 1000 |

Tests réalisés sur les éprouvettes :

La présente invention est illustrée plus en détail par les exemples non limitatif suivant.

Les compositions notés E1, E2, E3 et E4 dans le tableau ci-dessous sont des compositions conformes à l'invention tandis que les compositions EC1, EC2, EC3 et EC4 sont des compositions selon l'art antérieur et/ou non conforme à la présente invention.

|   | Constituant 1 | Taux 1 (%) | Constituant 2 | Taux 2 (%) | Constituant 3 | Taux 3 (%) |
|---|---|---|---|---|---|---|
| E1 | 20MA08T | 72,75 | 3410 | 27 | GLYEO | 0,25 |
| E2 | 24MA02T | 79,75 | 3410 | 20 | GLYEO | 0,25 |
| E3 | 20MA08T | 79,75 | 3410 | 20 | GLYEO | 0,25 |
| E4 | 20MA08T | 89,75 | 3410 | 10 | GLYEO | 0,25 |
| EC1 | 3345PV | 98,2 | TBEC | 1,5 | MTS | 0,3 |
| EC2 | 20MA08T | 98,75 | 3410 | 1 | GLYEO | 0,25 |
| EC3 | 20MA08T | 59,75 | 3410 | 40 | GLYEO | 0,25 |
| EC4 | 20MA08A | 79,75 | 3410 | 20 | GLYEO | 0,25 |

Les exemples de composition selon l'invention présentent tous les mêmes épaisseurs mais il est bien entendu que l'homme du métier pourra les faire varier en fonction de l'application du module photovoltaïque et des performances de ce dernier.

On notera également que les éprouvettes visées ci-dessus présentent des quantités identiques de silane, fixées sensiblement à 0,25% du poids de la composition. Néanmoins, des tests complémentaires ont permis d'identifier que la quantité de silane dans la composition pouvait être représentée entre 0,1% et 2% en poids de ladite composition.

Vieillissement des structures :

Un vieillissement accéléré des structures est réalisé par DHT (« Damp Heat Test »). Toutes les structures sont placées dans une enceinte climatique régulée à 85°C et 85% HR (humidité relative).Ce vieillissement dure 2000 heures. L'évolution du niveau de jaune (YI) des modules est suivie au cours de ce DHT.

Mesure de l'indice de jaune YI :

L'indice de jaune YI est mesuré sur des structures verre / encapsulant / backsheet à l'aide d'un spectrocolorimètre de la marque Minolta et selon la norme ASTM E313. Le backsheet utilisé pour cette mesure est un KPK (PVDF / PET / PVDF). Les conditions de mesures sont les suivantes :

- Longueur d'onde : 360 nm - 740 nm (nanomètre)
- Illuminant : C
- Angle : 2°
- Ouverture de mesure : MAV 8 mm (millimètre)
- Fond : plaque blanche « Cera »

La valeur retenue pour cet essai est l'évolution du YI, notée ΔYI, après un vieillissement de 2000h en conditions DHT.

$$\Delta YI = YI_{2000h} - YI_{0h}$$

Test de fluage :

Le test de fluage est réalisé sur des structures verre / encapsulant / verre (avec des plaques de verre de longueur L = 70 mm). Après lamination, les modules-test sont placés sur une structure métallique formant un angle de 70° avec l'horizontal. Chaque module est retenu par un rebord recouvrant une partie de l'épaisseur de la première couche de verre.

Cette structure est placée à 100°C dans une étuve. Sous le poids de la seconde couche de verre, un fluage peut-être observé. La valeur de fluage mesurée est donc la distance parcourue par la seconde plaque de verre après 500 heures dans ces conditions. Cette distance est comprise entre 0 mm (pas de fluage) et 70 mm (fluage complet, séparation de la structure).

Test d'adhésion sur une couche de verre :

Le niveau d'adhésion entre l'encapsulant et le verre est mesuré sur des structures verre / encapsulant / backsheet à partir d'un test de pelage à 90° effectué à 50 mm/min (millimètre par minute) sur un dynamomètre Zwick 1445. Le backsheet utilisé pour cette mesure est une monocouche constitué d'Apolhya®, fabriqué et vendu par la demanderesse. Les conditions de mesures sont les suivantes :

- Vitesse de déplacement de la traverse : 50 mm/min
- Largeur découpe éprouvette : 10 mm
- Angle de pelage : 90°

Le résultat d'adhésion est exprimé en N/mm.

Des tests sur l'encapsulant ont également été réalisés pour vérifier que cette nouvelle structure conserve d'excellentes propriétés, c'est-à-dire des propriétés identiques, relativement aux propriétés d'un encapsulant conforme à celui décrit dans le document WO 09138679, à savoir notamment concernant sa transparence, son trouble, ses propriétés mécaniques, thermomécaniques, ignifuges et ses propriétés d'isolation électrique. Ces tests se sont révélés positifs.

Les compositions selon l'invention remplissent donc les critères pour pouvoir être très avantageusement utilisée comme liant ou encapsulant dans les modules solaires.

**Résultats des tests réalisés sur les éprouvettes des différentes formulations :**

| Test | ΔYI (DHT2000h) | Adhésion (N/mm) | Fluage (mm) |
|------|----------------|-----------------|-------------|
| E1 | 2 | 5,4 | 0 |
| E2 | 1,9 | 5,6 | 0 |

(suite)

| Test | △YI (DHT2000h) | Adhésion (N/mm) | Fluage (mm) |
|------|----------------|-----------------|-------------|
| E3   | 1,7            | 6,1             | 0           |
| E4   | 1,4            | 5,1             | 0           |
| EC1  | 6              | 6,2             | 0           |
| EC2  | 1,3            | 0,9             | 0           |
| EC3  | 2,2            | 5,7             | 8           |
| EC4  | 1,4            | 5,9             | 70          |

Dans le cadre de la présente invention, les valeurs recherchées sur les différents tests susmentionnés se présentent comme suit :

- l'indice de jaune, après 2000 heures DHT, doit être inférieur à 3,
- l'adhésion, pour une telle structure et application, doit être supérieure à 5 N/mm,
- le fluage doit être inférieur à 3 millimètres.

Dans l'hypothèse où le terpolymère est présent dans la composition selon l'invention entre 8% et 22%, l'avantage obtenu est un meilleur résultat sur le test de fluage réalisé à une température supérieure à 100°C, typiquement 110°C ou plus.

**Revendications**

1. Encapsulant (22) de module photovoltaïque (20), destiné à venir enrober une pile photovoltaïque (10), constitué par une composition ne comprenant aucun agent de réticulation et comprenant :

   - un copolymère éthylène - acrylate d'alkyle, ledit copolymère représentant entre 70% et 96% du poids de ladite composition ;
   - un silane, représentant entre 0,1% et 2% du poids de ladite composition ;

   **caractérisé en ce qu'**elle comprend en outre un terpolymère éthylène - acrylique ester - anhydride maléique ou méthacrylate de glycidyle, ledit terpolymère représentant de 2% à 29,9% du poids de ladite composition.

2. Encapsulant (22) selon la revendication 1, **caractérisé en ce que** le susdit terpolymère représente entre 8% et 22% du poids de ladite composition.

3. Encapsulant (22) selon la revendication 1 ou 2, **caractérisé en ce que**, pour le susdit copolymère, le taux massique d'éthylène est compris entre 60% et 85%, de préférence entre 70% et 84%, et le taux massique d'acrylate d'alkyle est compris entre 15% et 40%, de préférence entre 16% et 30%.

4. Encapsulant (22) selon l'une quelconque des revendications précédentes, **caractérisé en ce que** le silane consiste en un époxysilane ou un aminosilane.

5. Encapsulant (22) selon la revendication 4, **caractérisé en ce que** le silane consiste en le glycidyl-3-oxypropyl-triéthoxy-silane.

6. Encapsulant (22) selon l'une quelconque des revendications précédentes, **caractérisé en ce que** le susdit copolymère est présent entre 75% et 95% en poids de ladite composition.

7. Encapsulant (22) selon l'une quelconque des revendications précédentes, **caractérisé en ce que** la composition consiste uniquement en les susdits copolymère, terpolymère et silane.

8. Encapsulant (22) selon l'une quelconque des revendications 1 à 6, **caractérisé en ce que** la composition comprend en outre des additifs destinés à conférer des propriétés particulières additionnelles, en particulier des plastifiants, des promoteurs d'adhésion, des stabilisants et absorbeurs UV, des antioxydants, des agents retardateurs de flamme et/ou des charges.

9. Utilisation de l'encapsulant (22) selon l'une quelconque des revendications précédentes dans un module photovoltaïque (20).

10. Module photovoltaïque (20) comprenant une structure constituée d'une association d'au moins un encapsulant (22) et un frontsheet (24) ou un backsheet (26), **caractérisé en ce que** l'encapsulant (22) est selon l'une quelconque des revendications 1 à 8.

**Patentansprüche**

1. Verkapselungsmittel (22) eines Photovoltaikmoduls (20), das zum Umhüllen einer Photovoltaikzelle (10) bestimmt ist, das aus einer Zusammensetzung besteht, die kein Vernetzungsmittel enthält, und Folgendes enthält:

   - ein Ethylen-Alkylacryl-Copolymer, wobei das Copolymer zwischen 70 Gew.-% und 96 Gew.-% der Zusammensetzung ausmacht;
   - ein Silan, das zwischen 0,1 Gew.-% und 2 Gew.-% der Zusammensetzung ausmacht;

   **dadurch gekennzeichnet, dass** es ferner ein Ethylen-Acrylester-Maleinsäureanhydrid- oder Glycidylmethacrylat-Terpolymer enthält, wobei das Terpolymer 2 Gew.-% bis 29,9 Gew.-% der Zusammensetzung ausmacht.

2. Verkapselungsmittel (22) nach Anspruch 1, **dadurch gekennzeichnet, dass** das vorgenannte Terpolymer zwischen 8 Gew.-% und 22 Gew.-% der Zusammensetzung ausmacht.

3. Verkapselungsmittel (22) nach Anspruch 1 oder 2, **dadurch gekennzeichnet, dass** für das vorgenannte Copolymer der Masseanteil an Ethylen zwischen 60 % und 85 %, vorzugsweise zwischen 70 % und 84 %, liegt und der Masseanteil an Alkylacrylat zwischen 15 % und 40 %, vorzugsweise zwischen 16 % und 30 %, liegt.

4. Verkapselungsmittel (22) nach einem der vorhergehenden Ansprüche, **dadurch gekennzeichnet, dass** das Silan aus einem Epoxysilan oder einem Aminosilan besteht.

5. Verkapselungsmittel (22) nach Anspruch 4, **dadurch gekennzeichnet, dass** das Silan aus Glycidyl-3-oxypropyltriethoxysilan besteht.

6. Verkapselungsmittel (22) nach einem der vorhergehenden Ansprüche, **dadurch gekennzeichnet, dass** das vorgenannte Copolymer zwischen 75 % und 95 Gew.-% der Zusammensetzung ausmacht.

7. Verkapselungsmittel (22) nach einem der vorhergehenden Ansprüche, **dadurch gekennzeichnet, dass** die Zusammensetzung nur aus dem vorgenannten Copolymer, dem vorgenannten Terpolymer und dem vorgenannten Silan besteht.

8. Verkapselungsmittel (22) nach einem der Ansprüche 1 bis 6, **dadurch gekennzeichnet, dass** die Zusammensetzung ferner Additive enthält, die dazu bestimmt sind, zusätzliche spezielle Eigenschaften zu verleihen, insbesondere Weichmacher, Haftvermittler, Stabilisatoren und UV-Absorber, Antioxidantien, Flammschutzmittel und/oder Füllstoffe.

9. Verwendung des Verkapselungsmittels (22) nach einem der vorhergehenden Ansprüche in einem Photovoltaikmodul (20).

10. Photovoltaikmodul (20), enthaltend eine Struktur, die aus einer Verbindung von mindestens einem Verkapselungsmittel (22) und einer Vorderschicht (24) oder einer Rückschicht (26) besteht, **dadurch gekennzeichnet, dass** das Verkapselungsmittel (22) nach einem der Ansprüche 1 bis 8 ist.

**Claims**

1. A photovoltaic module (20) encapsulant (22) intended to encase a photovoltaic cell (10), consisting of a composition not comprising any crosslinking agent and comprising:

   - an ethylene/alkyl acrylate copolymer, said copolymer representing between 70% and 96% of the weight of said composition;
   - a silane, representing between 0.1% and 2% of the weight of said composition;

   **characterized in that** it additionally comprises an ethylene/acrylic ester/maleic anhydride or glycidyl methacrylate terpolymer, said terpolymer representing from 2% to 29.9% of the weight of said composition.

2. The encapsulant (22) as claimed in claim 1, **characterized in that** the said terpolymer represents between 8% and 22% of the weight of said composition.

3. The encapsulant (22) as claimed in claim 1 or 2, **characterized in that**, for the said copolymer, the content by weight of ethylene is between 60% and 85%, preferably between 70% and 84%, and the content by weight of alkyl acrylate is between 15% and 40%, preferably between 16% and 30%.

4. The encapsulant (22) as claimed in any one of the preceding claims, **characterized in that** the silane consists of an epoxysilane or an aminosilane.

5. The encapsulant (22) as claimed in claim 4, **characterized in that** the silane consists of (3-glycidyloxypropyl)triethoxysilane.

6. The encapsulant (22) as claimed in any one of the preceding claims, **characterized in that** the said copolymer is present at between 75% and 95% by weight of said composition.

7. The encapsulant (22) as claimed in any one of the preceding claims, **characterized in that** the composition consists solely of the said copolymer, the said terpolymer and the said silane.

8. The encapsulant (22) as claimed in any one of claims 1 to 6, **characterized in that** the composition additionally comprises additives intended to confer additional specific properties, in particular plasticizers, adhesion promoters, UV stabilizers and absorbers, antioxidants, flame retardants and/or fillers.

9. The use of the encapsulant (22) as claimed in any one of the preceding claims in a photovoltaic module (20).

10. A photovoltaic module (20) comprising a structure consisting of a combination of at least one encapsulant (22) and a front sheet (24) or a back sheet (26), **characterized in that** the encapsulant (22) is as claimed in any one of claims 1 to 8.

(a)        (b)        (c)

FIG.1

FIG.2

EP 3 157 999 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2006095911 A

- WO 09138679 A

**Littérature non-brevet citée dans la description**

- Handbook of polymer foams and technology. 198-204

- Handbook of Photovoltaic Science and Engineering. Wiley, 2003